# EUROPÄISCHE PATENTSCHRIFT

(11) **EP 2 043 151 B1**
(45) Veröffentlichungstag und Bekanntmachung des Hinweises auf die Patenterteilung: **09.08.2017**
(21) Anmeldenummer: 08164597.0
(22) Anmeldetag: 18.09.2008
(51) Int. Cl.: H01L 25/04

(54) **Strahlungsemittierende Vorrichtung**
Ray-emitting device
Dispositif émettant des rayonnements

(30) Priorität: 27.09.2007 DE 102007046336; 20.12.2007 DE 102007061473
(43) Veröffentlichungstag der Anmeldung: 01.04.2009
(73) Patentinhaber: OSRAM OLED GmbH, 93049 Regensburg (DE)
(72) Erfinder: Diekmann, Karsten, 94371, Rattenberg (DE); Klein, Markus, 93105, Tegernheim (DE)
(74) Vertreter: Epping - Hermann - Fischer

(56) Entgegenhaltungen:
- EP-A2- 1 534 049
- US-A1- 2005 248 935
- US-A1- 2006 017 059
- US-B1- 6 515 417

## Beschreibung

Die Erfindung betrifft eine strahlungsemittierende Vorrichtung.

Im Bereich strahlungsemittierender, organischer Bauelemente gibt es derzeit Einschränkungen bezüglich der maximal herstellbaren Größe eines einzelnen strahlungsemittierenden, organischen Bauelements. Diese Einschränkungen werden beispielsweise verursacht durch die Auslegung der zur Herstellung verfügbaren Maschinen, oder durch die Problematik, eine für den Betrieb eines großflächigen strahlungsemittierenden, organischen Bauelements erforderliche konstante Stromdichte zu erzeugen.

Die Druckschrift US 2005/248935 beschreibt eine Lichtquelle mit OLED-Kacheln, die durch auf den Kacheln angeordnete Kontakte miteinander verschaltet werden können, wobei die Kontakte beispielsweise auf jeweils vorstehenden Teilen eines Substrats und einer Verkapselung angeordnet sein können, die gegeneinander verschoben sind, oder auf vorstehenden Teilen eines Kachelrahmens, die in entsprechende Vertiefungen eines Rahmens einer weiteren Kachel geschoben werden können. Die Kacheln können weiterhin mittels flexiblen oder als Gelenken ausgebildeten Verbindungselementen miteinander mechanisch und elektrisch verbunden werden.

Die Druckschrift US 6,515,417 beschreibt OLEDs, die auf einen flexiblen Polymerfilm als Träger geklebt werden und die über elektrische Kontakte im Träger kontaktiert und miteinander verschaltet werden.

Die Druckschrift EP 1 534 049 beschreibt eine Lichtquelle mit OLED-Kacheln, die in einer matrixartigen Anordnung miteinander verklebt und verschaltet sind.

Die Druckschrift US 2006/017059 beschreibt eine Rolle oder eine Ziehharmonika-artige Anordnung aus OLEDs, die von einem flexiblen Substrat und einer flexiblen Abdeckung umgeben sind, die beide aus einem Polymerfilm sein können.

Der Erfindung liegt daher die Aufgabe zugrunde, eine Möglichkeit zur Realisierung einer großflächigen strahlungsemittierenden Vorrichtung anzugeben.

Diese Aufgabe wird erfindungsgemäß gelöst durch die strahlungsemittierende Vorrichtung des Patentanspruchs 1 und durch den Gegenstand des Patentanspruchs 8. Weiterbildungen und Ausgestaltungen sind jeweils Gegenstände der abhängigen Ansprüche.

Eine strahlungsemittierende Vorrichtung weist ein erstes und mindestens ein zweites strahlungsemittierendes, organisches Bauelement auf, wobei das erste strahlungsemittierende, organische Bauelement mit dem mindestens zweiten strahlungsemittierenden, organischen Bauelement elektrisch und mechanisch verbunden ist. Ein strahlungsemittierendes, organisches Bauelement umfasst jeweils ein Substrat mit einer ersten Hauptfläche, auf die eine erste Elektrode aufgebracht ist, eine jeweils darauf angeordnete organische Schichtenfolge, eine jeweils darauf angeordnete zweite Elektrode und eine auf dem jeweiligen Substrat über der jeweiligen organischen Schichtfolge und der jeweiligen zweiten Elektrode angeordnete Verkapselung. Die jeweilige organische Schichtenfolge weist mindestens eine organische Schicht auf, die geeignet ist, Strahlung zu erzeugen.

Dabei kann die organische Schichtenfolge als organische, strahlungsemittierende Diode (OLED) ausgeführt sein. Die organische Schichtenfolge bzw. die OLED kann beispielsweise ein Substrat aufweisen, wobei die erste Elektrode auf dem Substrat angeordnet sein kann. Da die erste Elektrode reflektierend ausgeführt ist und die zweite Elektrode transparent, kann das bedeuten, dass die Primärstrahlung in eine Richtung vom Substrat weg abgestrahlt werden kann ("top emitter"). Alternativ kann die zweite Elektrode direkt auf dem Substrat angeordnet sein, so dass die Primärstrahlung durch das Substrat hindurch abgestrahlt werden kann ("bottom emitter"). Alternativ kann sowohl die erste als auch die zweite Elektrode transparent für die emittierte Primärstrahlung sein ("top und bottom emitter"). Über der ersten Elektrode kann ein funktionaler Bereich mit einer oder mehreren funktionalen Schichten aus organischen Materialien aufgebracht sein. Die funktionalen Schichten können dabei beispielsweise ein oder mehrere Elektroneninjektionsschichten ("electron injection layer", EIL), Elektronentransportschichten ("electron transport layer", ETL), Lochsperrschichten ("hole blocking layer", HBL,) elektrolumineszierende Schichten ("electroluminescent layer", EL), Elektronsperrschichten ("electron blocking layer", EBL), Lochtransportschichten ("hole transport layer", HTL) und/oder Lochinjektionsschichten ("hole injection layer", HIL) aufweisen. Die Rekombination von Elektronen und Löchern führt zur Elektrolumineszenz. Einzelne Schichten können auch Funktionalitäten mehrerer der vorgenannten Schichten aufweisen. So kann eine Schicht beispielsweise als HIL und als HTL oder als EIL und als ETL dienen. Der aktive Bereich kann beispielsweise durch ein EL gebildet sein oder ein EL umfassen. Weiterhin kann der aktive Bereich beispielsweise auch im Bereich einer Grenzfläche zweier Schichten ausgebildet sein, etwa an der Grenzfläche zwischen einem ETL und einem HTL.

Beispielsweise kann das Substrat Glas, Quarz, Kunststofffolien, Metall, Metallfolien, Siliziumwafer oder ein beliebiges anderes geeignetes Substratmaterial umfassen. Ist die organische Schichtenfolge bzw. die OLED als so genannter "bottom emitter" ausgeführt, das heißt, dass die im aktiven Bereich erzeugte Primärstrahlung durch das Substrat abgestrahlt wird, so kann das Substrat transparent für zumindest einen Teil der Primärstrahlung sein.

Die erste Elektrode kann als Kathode ausgeführt sein und somit als Elektronen-injizierendes Material dienen. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen.

Die transparente zweite Elektrode, die als Anode ausgeführt sein kann und somit als Löcher-injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, 2nSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin kann es möglich sein, dass die TCOs nicht zwingend einer stöchiometrischen Zusammensetzung entsprechen und auch p- oder n-dotiert sein können. Alternativ oder zusätzlich kann die zweite Elektrode auch ein Metall, beispielsweise wie im Zusammenhang mit der ersten Elektrode genannt, aufweisen. Beispielsweise kann die zweite Elektrode eine Metallschicht umfassen, die zumindest teilweise transparent für die Primärstrahlung ist. Weiterhin kann die zweite Elektrode auch ein organisches elektrisch leitendes Material aufweisen.

Die funktionalen Schichten können organische Polymere, organische Oligomere, organische Monomere, organische kleine, nicht-polymere Moleküle ("small molecules") oder Kombinationen daraus aufweisen. Abhängig von den Materialien in den funktionalen Schichten kann die erzeugte erste Strahlung einzelne Wellenlängen oder Bereiche oder Kombinationen daraus aus dem ultravioletten bis infrarotem Spektralbereich aufweisen.

Weiterhin kann die organische Schichtenfolge eine Verkapselung aufweisen, um für die Elektroden und den funktionalen Bereich einen Schutz vor Feuchtigkeit und/oder oxidierenden Substanzen wie etwa Sauerstoff zu erreichen. Dabei kann die Verkapselung die gesamte organische Schichtenfolge einschließlich des Substrats umgeben. Alternativ kann das Substrat einen Teil der Verkapselung bilden. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können. Weiterhin kann die Verkapselung transparent ausgebildet sein, insbesondere bei einer als "top emitter" ausgebildeten organischen Schichtenfolge.

Mit Vorteil stellt die Verbindung mindestens zweier strahlungsemittierender, organischer Bauelemente ein modulares Konzept dar, mit dessen Verwendung sich strahlungsemittierende Vorrichtungen beliebiger Größe realisieren lassen.

In einer weiteren Ausführung ist bei der strahlungsemittierenden Vorrichtung ein elektrischer Kontakt des ersten strahlungsemittierenden, organischen Bauelements mit einem ersten elektrischen Kontakt des mindestens zweiten strahlungsemittierenden, organischen Bauelements in serieller oder paralleler Weise elektrisch verbunden. Ein zweiter elektrischer Kontakt des mindestens zweiten strahlungsemittierenden, organischen Bauelements ist mit einer Energiequelle verbunden. Die Verbindung zwischen dem ersten und dem mindestens zweiten strahlungsemittierenden, organischen Bauelement der strahlungsemittierenden Vorrichtung ist als flexible Kontaktbrücke ausgebildet. Dabei ist die Kontaktbrücke flexibler als das jeweilige Substrat des ersten und des mindestens zweiten strahlungsemittierenden, organischen Bauelements ausgeführt.

Vorteilhafterweise sind damit trotz der Verwendung rigider strahlungsemittierender, organischer Bauelemente strahlungsemittierende Vorrichtungen, die gekrümmte Formen aufweisen oder/und in allen drei räumlichen Dimensionen beweglich sind, realisierbar.

In einem Beispiel, das nicht zur Erfindung gehört, ist die flexible Kontaktbrücke der strahlungsemittierenden Vorrichtung als Flexfolie ausgeführt.

In einem Beispiel, das nicht zur Erfindung gehört, ist die flexible Kontaktbrücke der strahlungsemittierenden Vorrichtung als Printed Circuit Board ausgeführt.

In der Erfindung ist die flexible Kontaktbrücke als klemmbarer, metallisch verbrückter Doppelpin ausgeführt.

In einer Weiterbildung weist die strahlungsemittierende Vorrichtung eine verformbare Ummantelung, die das erste und das damit verbundene mindestens zweite strahlungsemittierende, organische Bauelement umschließt, auf.

In einer weiteren Ausführungsform umfasst die verformbare Ummantelung einen für die von den strahlungsemittierenden, organischen Bauelementen emittierte Strahlung transparenten Kunststoff. Dieser Kunststoff ist beispielsweise als eine mit Silikon gefüllte transparente Folie ausgeführt.

Dadurch lassen sich beliebig verformbare strahlungsemittierende Vorrichtungen, beispielsweise Beleuchtungen realisieren.

In einer weiteren Ausführungsform umfasst die verformbare Ummantelung Plexiglas.

Dadurch lassen sich stabile strahlungsemittierende Vorrichtungen, beispielsweise Beleuchtungen, unterschiedlicher Formen herstellen.

In einer Weiterbildung umfasst eine strahlungsemittierende Vorrichtung einen tragenden Rahmen, in dem das erste und das mindestens zweite strahlungsemittierende, organische Bauelement der strahlungsemittierenden Vorrichtung angeordnet und mechanisch miteinander verbunden sind. Die elektrische Kontaktierung der strahlungsemittierenden, organischen Bauelemente kann dabei über Federkontakte, Kabel und / oder Clips erfolgen. Das Material des tragenden Rahmens kann dabei rigide oder flexibel ausgeführt sein.

In einer weiteren Ausführungsform sind die strahlungsemittierenden, organischen Bauelemente der strahlungsemittierenden Vorrichtung über den tragenden Rahmen zusätzlich elektrisch miteinander verbunden.

In einer weiteren Ausführungsform ist der tragende Rahmen der strahlungsemittierenden Vorrichtung als flexibles Trägergitter mit quer zueinander verlaufenden Stegstrukturen ausgeführt. Die strahlungsemittierenden, organischen Bauelemente sind in den Zwischenräumen des flexiblen Trägergitters angeordnet. Das Material des flexiblen Trägergitters ist dabei flexibler als die jeweiligen Substrate der in dem Trägergitter angeordneten strahlungsemittierenden, organischen Bauelemente ausgeführt.

Damit sind trotz der Verwendung rigider strahlungsemittierender, organischer Bauelemente strahlungsemittierende Vorrichtungen, die gekrümmte Formen aufweisen oder/und in allen drei räumlichen Dimensionen beweglich sind, realisierbar.

In einer Ausführungsform umfasst eine Beleuchtungseinrichtung eine Vielzahl von strahlungsemittierenden, organischen Bauelementen, wobei diese matrixartig in dem flexiblen Trägergitter angeordnet und über dieses parallel, seriell oder in einer Kombination aus parallel und seriell elektrisch miteinander verbunden sind.

In einer Weiterbildung weist die Beleuchtungseinrichtung einen auf der Vielzahl von strahlungsemittierenden, organischen Bauelementen und dem flexiblen Trägergitter befestigten flexiblen Deckel auf. Das Material des flexiblen Deckels weist dabei eine gleichgroße Flexibilität auf wie das Material des flexiblen Trägergitters.

In einer weiteren Ausführungsform weist der Deckel der Beleuchtungseinrichtung Stege auf, die über den Gitterlinien des flexiblen Trägergitters angeordnet sind. Diese Stege sind also entsprechend der nicht leuchtenden Bereiche der Beleuchtungseinrichtung ausgeführt.

Dadurch lassen sich in allen drei räumlichen Dimensionen verformbare Beleuchtungseinrichtungen beliebiger Größe realisieren.

In einer weiteren Ausführungsform umfasst eine strahlungsemittierende Vorrichtung eine Vielzahl von strahlungsemittierenden, organischen Bauelementen, wobei die strahlungsemittierenden, organischen Bauelemente so in dem tragenden Rahmen angeordnet sind, dass jeweils ein strahlungsemittierendes, organisches Bauelement in ein mit Gelenken, beispielsweise vier Gelenken, ausgestattetes Rahmenteilstück eingebettet ist. Die Rahmenteilstücke sind über die Gelenke derart verbunden und gegeneinander verklappbar, dass der Rahmen in seiner Gesamtheit ein Ziehharmonikagerüst bildet. Im gefalteten Zustand kommt somit ein strahlungsemittierendes, organisches Bauelement auf seinem benachbarten strahlungsemittierenden, organischen Bauelement zum Liegen. Dabei weisen die strahlungsemittierenden, organischen Bauelemente einen Schutz gegen Abnutzung durch Berührung und eine Isolierung auf. Im auseinander gezogenen Zustand der strahlungsemittierenden Vorrichtung bilden die strahlungsemittierenden, organischen Bauelemente eine ebene Fläche.

Damit lassen sich faltbare strahlungsemittierende Vorrichtungen beliebiger Größe realisieren.

In einer weiteren Ausführungsform der ziehharmonikaförmigen strahlungsemittierenden Vorrichtung erfolgt der elektrische Kontakt zwischen den einzelnen strahlungsemittierenden, organischen Bauelementen über elektrisch leitende Bereiche des Rahmens. Damit erübrigt sich ein unmittelbarer elektrischer Kontakt zwischen den einzelnen strahlungsemittierenden, organischen Bauelementen.

In einer Ausführungsform ist bei einer strahlungsemittierenden Vorrichtung der tragende Rahmen als Textilstoff ausgeführt. Dabei sind das erste und das mindestens zweite strahlungsemittierende elektronische Bauelement in den von dem Textilstoff gebildeten textilen Rahmen eingelagert.

Dadurch lassen sich großflächige strahlungsemittierende Produkte herstellen, die wie ein Vorhang oder eine Decke mit Auswölbungen aufgehängt werden oder über entsprechend geformte Körper ausgebreitet werden können.

In einer weiteren Ausführungsform weist ein selbsttragendes, strahlungsemittierendes Baumaterial mindestens eine strahlungsemittierende Vorrichtung auf, wobei das selbsttragende, strahlungsemittierende Baumaterial beispielsweise als Beleuchtung in einer abgehängten Decke, als Wandleuchte oder als begehbare Beleuchtung einsetzbar ist.

Dadurch kann das Baumaterial als tragendes, leuchtendes Element einer architektonischen Konstruktion verwendet werden.

In einem Beispiel einer strahlungsemittierenden Vorrichtung, das nicht zur Erfindung gehört, weisen das erste und das mindestens zweite strahlungsemittierende, organische Bauelement jeweils einen Kontaktbereich auf, in dem ein elektrisch leitfähiges Material außerhalb der Verkapselungen vorhanden ist, welches die unter den Verkapselungen befindlichen ersten und zweiten Elektroden elektrisch kontaktiert, wobei das erste und das mindestens zweite strahlungsemittierende, organische Bauelement so zueinander angeordnet sind, dass ihre Kontaktbereiche überlappen. Die überlappenden Kontaktbereiche sind über eine leitende Verbindung elektrisch verbunden. Ein Kontaktbereich kann auf Seite des Substrats als Substratkontaktbereich oder auf Seite der Verkapselung als Verkapselungskontaktbereich ausgebildet sein. Die leitende Verbindung kann dabei einen elektrisch leitenden Klebstoff aufweisen. Alternativ dazu kann die leitende Verbindung beispielsweise auch ein Lot umfassen. Alternativ weist die leitende Verbindung einen elektrisch anisotrop leitenden Klebstoff ("Anisotropic conductive film", ACF) auf.

Dadurch kann das Verhältnis von leuchtender Fläche zur Gesamtfläche der strahlungsemittierenden Vorrichtung verbessert werden.

In einem weiteren Beispiel, das nicht zur Erfindung gehört, ragt beim ersten strahlungsemittierenden, organischen Bauelement das Substrat über die Verkapselung hinaus, so dass ein über die Verkapselung hinausragender Substratkontaktbereich auf dem Substrat ausgebildet ist. Beim mindestens zweiten strahlungsemittierenden, organischen Bauelement ragt die Verkapselung über das Substrat hinaus, so dass ein über das Substrat hinausragender Verkapselungskontaktbereich auf der Verkapselung ausgebildet ist. Das erste und das mindestens zweite strahlungsemittierende, organische Bauelement sind dabei so zueinander angeordnet, dass der Substratkontaktbereich des ersten strahlungsemittierenden, organischen Bauelements und der Verkapselungskontaktbereich des mindestens zweiten strahlungsemittierenden, organischen Bauelements überlappend angeordnet sind.

In einem weiteren Beispiel, das nicht zur Erfindung gehört, ragt beim ersten und beim mindestens zweiten strahlungsemittierenden, organischen Bauelement jeweils das Substrat über die Verkapselung heraus, wobei jeweils ein Substratkontaktbereich gebildet ist. Das erste und das mindestens zweite strahlungsemittierende, organische Bauelement sind so zueinander angeordnet, dass der Substratkontaktbereich des mindestens zweiten strahlungsemittierenden, organischen Bauelements überlappend auf dem Substratkontaktbereich des ersten strahlungsemittierenden, organischen Bauelements angeordnet ist.

In einem weiteren Beispiel, das nicht zur Erfindung gehört, sind beim ersten und beim mindestens zweiten strahlungsemittierenden, organischen Bauelement jeweils das Substrat gegen die Verkapselung derart verschoben, dass jeweils auf einer Seite des strahlungsemittierenden, organischen Bauelements die Verkapselung über das Substrat herausragt und ein Verkapselungskontaktbereich gebildet wird und jeweils auf einer gegenüber liegenden Seite des strahlungsemittierenden, organischen Bauelements das Substrat über die Verkapselung herausragt und ein Substratkontaktbereich gebildet wird. Die strahlungsemittierenden, organischen Bauelemente sind so zueinander angeordnet, dass der Substratkontaktbereich des ersten strahlungsemittierenden, organischen Bauelements und der Verkapselungsbereich des mindestens zweiten strahlungsemittierenden, organischen Bauelements überlappend angeordnet sind.

In einem weiteren Beispiel, das nicht zur Erfindung gehört, ragt beim ersten und beim mindestens zweiten strahlungsemittierenden Bauelement das Substrat über die Verkapselung heraus, so dass das erste und das mindestens zweite strahlungsemittierende, organische Bauelement jeweils Substratkontaktbereiche bilden. Das erste und das mindestens zweite strahlungsemittierende, organische Bauelement sind räumlich benachbart zueinander angeordnet, so dass die jeweiligen Substratkontaktbereiche in Form einer Stosskontaktierung aneinander grenzen. Die jeweiligen Substratkontaktbereiche sind über eine leitende Verbindung elektrisch miteinander verbunden.

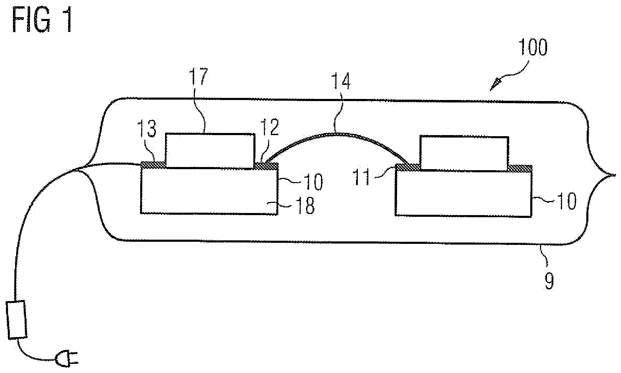

Weitere Vorteile und vorteilhafte Ausführungsformen und Weiterbildungen der Erfindung ergeben sich aus den im Folgenden in Verbindung mit den Figuren 1 bis 4D beschriebenen Ausführungsformen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

Es zeigen:
- Figur 1: eine schematische Darstellung einer strahlungsemittierenden Vorrichtung nach einer Ausführungsform der Erfindung,
- Figur 2A: eine schematische Darstellung eines tragenden Rahmens nach einer weiteren Ausführungsform der Erfindung,
- Figur 2B: eine schematische Darstellung einer optional flexiblen Beleuchtungseinrichtung nach einer weiteren Ausführungsform der Erfindung,
- Figur 3A: eine schematische Darstellung einer Ausführungsform einer strahlungsemittierenden Vorrichtung nach einer weiteren Ausführungsform der Erfindung,
- Figur 3B: eine schematische Darstellung eines Schnittbildes der strahlungsemittierenden Vorrichtung aus Figur 3A,
- Figur 3C: eine schematische Darstellung der Figur 3B im auseinander gezogenen Zustand,
- Figur 4A bis 4C: je eine schematische Darstellung eines Beispiels einer strahlungsemittierenden Vorrichtung, das nicht zur Erfindung gehört, mit überlappenden Kontaktbereichen,
- Figur 4D: eine schematische Darstellung eines weiteren Beispiels einer strahlungsemittierenden Vorrichtung, das nicht zur Erfindung gehört.

Figur 1 zeigt eine schematische Darstellung einer strahlungsemittierenden Vorrichtung 100 nach einer Ausführungsform der Erfindung. Die strahlungsemittierende Vorrichtung 100 weist zwei strahlungsemittierende, organische Bauelemente 10 auf. Jedes strahlungsemittierende, organische Bauelement 10 umfasst dabei jeweils ein Substrat 18, aufweisend eine erste Elektrode, eine organische Schichtenfolge und eine zweite Elektrode, sowie jeweils eine Verkapselung 17. Bei jedem strahlungsemittierenden, organischen Bauelement 10 sind auf der Oberfläche des Substrats 18 jeweils zwei elektrische Kontakte ausgebildet. Ein elektrischer Kontakt 11 des rechten strahlungsemittierenden, organischen Bauelements 10 ist dabei mit einem elektrischen Kontakt 12 des linken strahlungsemittierenden, organischen Bauelements 10 über eine elektrisch leitende Verbindung 14 verbunden. Ein elektrischer Kontakt 13 des linken strahlungsemittierenden, organischen Bauelements 10 ist mit einer externen Spannungsversorgung verbunden. Die elektrisch leitende Verbindung 14 ist dabei als flexible Kontaktbrücke ausgebildet. Des Weiteren weist die strahlungsemittierende Vorrichtung 100 eine Ummantelung 9 auf. Die Ummantelung 9 umschließt beide miteinander verbundenen strahlungsemittierenden, organischen Bauelemente 10. Hierbei umfasst die Ummantelung einen für die Strahlung der beiden strahlungsemittierenden, organischen Bauelemente 10 transparenten Kunststoff, beispielsweise eine mit Silikon gefüllte transparente Folie.

Die dargestellte strahlungsemittierende Vorrichtung 100 realisiert eine um den Faktor 2 größere Fläche als die derzeit maximal herstellbare Größe strahlungsemittierender, organischer Bauelemente. Das gezeigte modulare Konzept ist beliebig erweiterbar. Damit lassen sich also strahlungsemittierende Vorrichtungen, beispielsweise Beleuchtungen, beliebiger Größe herstellen.

Des Weiteren ist die gezeigte strahlungsemittierende Vorrichtung 100 in alle drei räumlichen Dimensionen beweglich. Durch die Verwendung der flexiblen Kontaktbrücke 14 können auch bei Verwendung rigider organischer strahlungsemittierender Bauelemente 10 flexible strahlungsemittierende Vorrichtungen 100 realisiert werden. Bei entsprechender Wahl des Materials für die Ummantelung 9 sind die strahlungsemittierenden, organischen Bauelemente 10 um bis zu 180 Grad gegeneinander verklappbar.

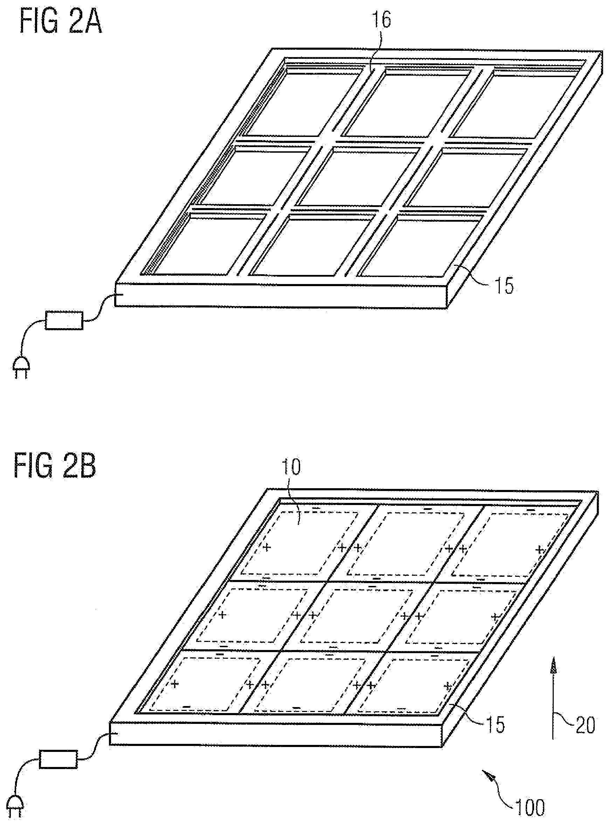

Figur 2A zeigt eine schematische Darstellung eines tragenden Rahmens nach einer weiteren Ausführungsform der Erfindung. Innerhalb eines viereckigen tragenden Rahmens 15 sind quer zueinander verlaufende Stegstrukturen, die einen Teilbereich des auf diese Weise gebildeten Gitters vom jeweiligen benachbarten Teilbereich abgrenzen, angeordnet. Sowohl in vertikaler als auch in horizontaler Richtung sind jeweils drei Teilbereiche vorhanden, so dass sich insgesamt neun Teilbereiche ergeben. Jeder Teilbereich ist dabei in seiner Größe so ausgelegt, dass er zur Aufnahme eines strahlungsemittierenden, organischen Bauelements 10 geeignet ist. Jeder einen Teilbereich des Gitters umschließende Rand weist an allen Seiten einen leitenden Bereich 16 auf. Die leitenden Bereiche 16 dienen zur elektrischen Kontaktierung der in den tragenden Rahmen 15 einzulegenden strahlungsemittierenden, organischen Bauelemente 10. Die Energieversorgung erfolgt mittels einer über einen Stecker anschließbaren externen Spannungsversorgung.

Dabei kann das Material für den tragenden Rahmen 15 flexibel gewählt werden, so dass dieser in allen drei räumlichen Dimensionen biegbar ist.

Die leitenden Bereiche 16 können auch an jeweils zwei gegenüberliegenden Seiten eines Teilbereichs des Gitters oder an einer Seite eines Teilbereichs des Gitters ausgeführt sein. Bei der letztgenannten Ausführung handelt es sich um einen zweigeteilten leitenden Bereich, der zwei gegeneinander isolierte elektrische Kontakte aufweist.

Figur 2B zeigt eine schematische Darstellung einer optional flexiblen Beleuchtungseinrichtung nach dem in Figur 2A beschriebenen Prinzip. Die dargestellte Beleuchtungseinrichtung 100 umfasst den tragenden Rahmen 15 aus Figur 2A, sowie neun strahlungsemittierende, organische Bauelemente 10. Dabei ist jedes organische strahlungsemittierende Bauelement 10 in einen Teilbereich des tragenden Rahmens 15 eingelegt. Die einzelnen strahlungsemittierenden, organischen Bauelemente 10

sind in der dargestellten Art und Weise parallel miteinander verschaltet. Dabei wird die elektrische Kontaktierung der strahlungsemittierenden, organischen Bauelemente 10 über die in Figur 2A gezeigten leitenden Bereiche 16 des tragenden Rahmens 15 realisiert.

Bei Verbinden des dargestellten Steckers mit einer externen Spannungsversorgung erzeugt die dargestellte Beleuchtungseinrichtung 100 Licht, das in einer dargestellten Abstrahlrichtung 20, also nach oben, abgegeben wird.

Die dargestellte Beleuchtungseinrichtung 100 kann trotz der Verwendung rigider strahlungsemittierender, organischer Bauelemente 10 in allen drei räumlichen Richtungen beweglich sein. Durch eine entsprechende Vergrößerung oder Verkleinerung des tragenden Rahmens 15 und den Einbau einer passenden Anzahl strahlungsemittierender, organischer Bauelemente 10 ist die Beleuchtungseinrichtung 100 beliebig skalierbar. Damit lassen sich also großflächige Beleuchtungseinrichtungen herstellen.

Die Verschaltung der strahlungsemittierenden, organischen Bauelemente 10 ist nicht auf die dargestellte parallele Art beschränkt, sondern kann auch als serielle Verschaltung oder als eine Kombination aus serieller und paralleler Verschaltung realisiert werden.

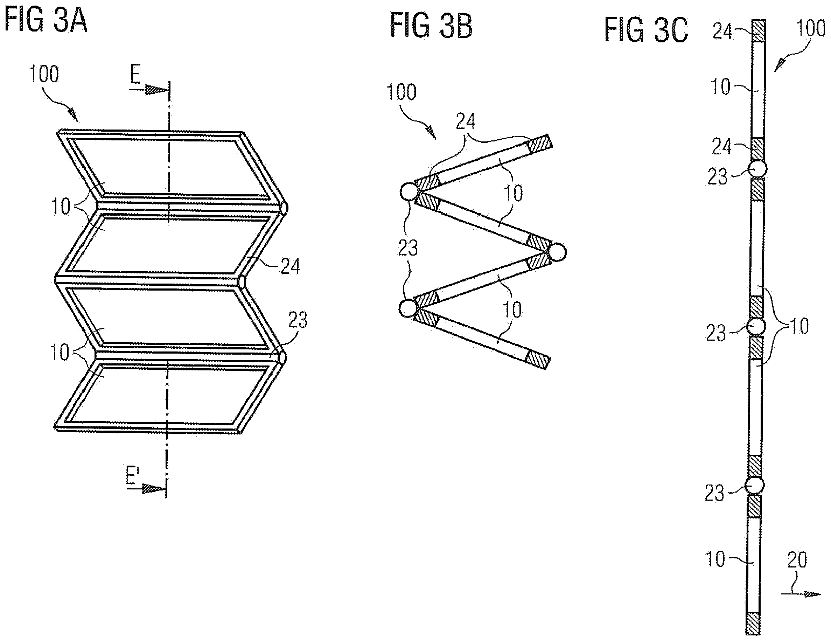

Figur 3A zeigt eine schematische Darstellung einer Ausführungsform einer strahlungsemittierenden Vorrichtung 100 nach einer weiteren Ausführungsform der Erfindung. Es ist die Vorderansicht einer weiteren strahlungsemittierenden Vorrichtung 100 dargestellt. Die strahlungsemittierende Vorrichtung 100 umfasst vier strahlungsemittierende, organische Bauelemente 10. Dabei ist jedes strahlungsemittierende, organische Bauelement 10 in ein, das strahlungsemittierende, organische Bauelement 10 an allen vier Seiten umschließendes Rahmenteilstück 24 eingelegt. Die Rahmenteilstücke 24 mit den darin enthaltenen strahlungsemittierenden, organischen Bauelementen 10 sind untereinander mechanisch jeweils über ein Scharnier 23 verbunden. Die Scharniere 23 sind dabei so ausgestaltet, dass es möglich ist, die einzelnen Rahmenteilstücke 24 gegeneinander zu verklappen, so dass im zusammengeklappten Zustand ein Rahmenteilstück 24 auf seinem benachbarten Rahmenteilstück 24 zum Liegen kommt. Dabei sind die einzelnen strahlungsemittierenden, organischen Bauelemente 10 durch eine entsprechend ausgelegte Verkapselung gegen mechanische Abnutzung geschützt. Die elektrische Verbindung zwischen den einzelnen strahlungsemittierenden, organischen Bauelementen 10 erfolgt über leitende Bereiche innerhalb der Rahmenteilstücke 24, die über in den Scharnieren 23 geführte elektrische Leitungen miteinander verbunden sind.

Figur 3B zeigt eine schematische Darstellung eines Schnittbildes der strahlungsemittierenden Vorrichtung 100 aus Figur 3A entlang des Schnittes E-E'. Dargestellt sind die vier strahlungsemittierenden, organischen Bauelemente 10, die jeweils in ein Rahmenteilstück 24 eingelegt sind. Die Rahmenteilstücke 24 sind über drei Scharniere 23 miteinander mechanisch verbunden. Die strahlungsemittierende Vorrichtung 100 ist hier im halb zusammengeklappten Zustand dargestellt.

Figur 3C zeigt eine schematische Darstellung der Figur 3B im auseinander gezogenen Zustand. Die vier strahlungsemittierenden, organischen Bauelemente 10 bilden dabei zusammen mit den Rahmenteilstücken 24 und den drei Scharnieren 23 eine ebene Fläche. Bei Anschluss einer externen Spannungsversorgung erzeugt die strahlungsemittierende Vorrichtung 100 Licht, das in Abstrahlrichtung 20, also nach rechts, abgegeben wird.

Die gezeigte strahlungsemittierende Vorrichtung 100 ist zusammenklappbar und kann somit beispielsweise einfacher transportiert werden. Durch Hinzufügen weiterer strahlungsemittierender, organischer Bauelemente 10, die eingelegt in weitere Rahmenteilstücke 24 über weitere Scharniere 23 mit der gezeigten Vorrichtung verbunden werden, lässt sich die gezeigte strahlungsemittierende Vorrichtung 100 beliebig erweitern. Somit lassen sich großflächige strahlungsemittierende Vorrichtungen realisieren.

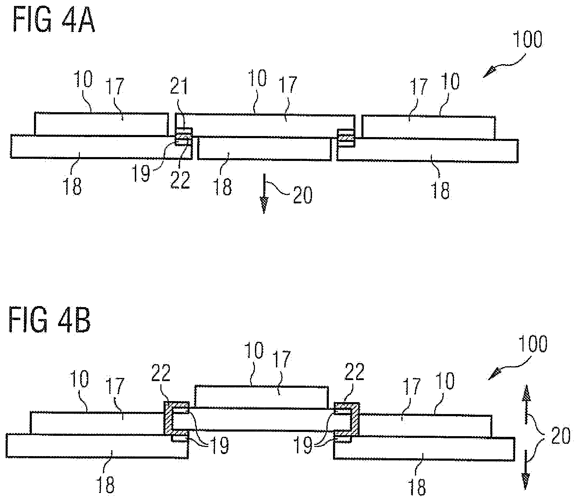

Figur 4A zeigt eine schematische Darstellung eines Beispiels einer strahlungsemittierenden Vorrichtung 100, das nicht zur Erfindung gehört, mit überlappenden Kontaktbereichen. Dargestellt sind drei strahlungsemittierende, organische Bauelemente 10. Auf beiden Seiten eines jeden strahlungsemittierenden, organischen Bauelements 10 sind Kontaktbereiche dargestellt. Ein Kontaktbereich umfasst dabei ein elektrisch leitfähiges Material, das unter der Verkapselung 17 mit jeweils der ersten oder der zweiten Elektrode eines strahlungsemittierenden, organischen Bauelements 10 verbunden ist, so dass für jede Elektrode ein eigener Kontaktbereich gebildet ist. Beim linken und beim rechten dargestellten strahlungsemittierenden, organischen Bauelement 10 ragt jeweils das Substrat 18 über die Verkapselung 17 hinaus. Somit ist jeweils ein über die Verkapselung 17 hinausragender Substratkontaktbereich 19 auf dem Substrat 18 ausgebildet. Beim mittleren strahlungsemittierenden, organischen Bauelement 10 ragt dagegen die Verkapselung 17 über das Substrat 18 hinaus. Damit wird ein über das Substrat 18 hinausragender Verkapselungskontaktbereich 21 auf der Verkapselung 17 ausgebildet. Die drei strahlungsemittierenden, organischen Bauelemente 10 sind so angeordnet, dass ihre Kontaktbereiche überlappen. Im Einzelnen bedeutet dies, dass der linke Verkapselungskontaktbereich 21 des mittleren strahlungsemittierenden, elektronischen Bauelements 10 den Substratkontaktbereich 19 des linken strahlungsemittierenden, elektronischen Bauelements 10 überlappt. Des Weiteren überlappt der rechte Verkapselungskontaktbereich 21 des mittleren strahlungsemittierenden, organischen Bauelements 10 den Substratkontaktbereich 19 des rechten strahlungsemittierenden, organischen Bauelements 10. Über eine elektrisch leitende Kontaktierung 22 sind die Kontaktbereiche der strahlungsemittierenden, organischen Bauelemente elektrisch miteinander verbunden und stoffschlüssig verklebt. Beispielsweise umfasst die leitende Kontaktierung 22 eine Leitpaste. Die Abstrahlrichtung 20 ist bei der gezeigten strahlungsemittierenden Vorrichtung 100 nach unten.

Mit der gezeigten Anordnung, also durch die Überlappung der Kontaktbereiche wird das Verhältnis von leuchtender Fläche zur Gesamtfläche der strahlungsemittierenden Vorrichtung 100 verbessert. Es folgt ein Beispiel für die Verbesserung: Bei einem beispielhaften strahlungsemittierenden, organischen Bauelement 10 beträgt die Kantenlänge der quadratischen Leuchtfläche 9 cm und die Kantenlänge des ebenfalls quadratischen Außenglases 10 cm. Somit ergibt sich eine umlaufende Breite eines nicht leuchtenden Bereichs von 0,5 cm. Die Breite des Kontaktbereichs beträgt dabei beispielsweise 0,25 cm. Bei einer nicht überlappenden Anordnung beträgt somit die Breite der nicht leuchtenden Fläche zwischen zwei benachbarten strahlungsemittierenden, organischen Bauelemente 10 genau 1 cm. Somit beträgt der Anteil der Leuchtfläche zur Gesamtfläche 81 %. Bei einer Verbesserung durch Überlappung der Kontaktbereiche wird der nicht leuchtende Bereich zwischen zwei strahlungsemittierenden, organischen Bauelementen 10 auf 0,75 cm verringert. Somit wird der Anteil der Leuchtfläche zur Gesamtfläche auf 85,2 % erhöht. Damit ergibt sich eine relative Verbesserung von 5,2 %.

In einem zweiten Beispiel mit einem anderen, ebenfalls quadratischen organischen, strahlungsemittierenden Bauelement 10 mit einer Kantenlänge der Leuchtfläche von 4 cm und einer Kantenlänge des Außenglases von 5 cm ergibt sich wieder ein umlaufender nicht leuchtender Bereich von 0,5 cm. Die umlaufende Breite des Kontaktbereiches beträgt wieder 0,25 cm. Somit ergibt sich bei einer benachbarten Anordnung der strahlungsemittierenden, organischen Bauelemente 10 ein 1 cm breiter nicht leuchtender Bereich. Der Anteil der Leuchtfläche zur Gesamtfläche beträgt hier 64 %. Bei der verbesserten Anordnung, also wenn die Kontaktbereiche überlappen, verringert sich der nicht leuchtende Bereich zwischen zwei strahlungsemittierenden, organischen Bauelementen 10 auf 0,75 cm. Damit erhöht sich der Anteil der Leuchtfläche zur Gesamtfläche auf 70,9 % und es ergibt sich eine relative Verbesserung von 10,8 %.

Figur 4B zeigt ein weiteres Beispiel einer strahlungsemittierenden Vorrichtung 100, das nicht zur Erfindung gehört, mit überlappenden Kontaktbereichen. Dargestellt sind drei strahlungsemittierende, organische Bauelemente 10, die jeweils ein Substrat 18 und jeweils eine Verkapselung 17 aufweisen. Dabei bildet jedes strahlungsemittierende, organische Bauelement 10 auf jeder Seite einen Substratkontaktbereich 19 aus. Die strahlungsemittierenden, organischen Bauelemente 10 sind dabei so angeordnet, dass das mittlere strahlungsemittierende, organische Bauelement 10 mit der Unterseite des Substrats über den von den rechten und linken strahlungsemittierenden, organischen Bauelementen 10 jeweils ausgebildeten Substratkontaktbereichen 19 angeordnet ist. Die strahlungsemittierenden, organischen Bauelemente 10 sind dabei über die leitende Verbindung 22 elektrisch miteinander verbunden. Die leitende Kontaktierung kann hier eine Leitpaste oder eine Flexfolie aufweisen. Die gezeigte strahlungsemittierende Vorrichtung 100 kann sowohl nach oben als auch nach unten oder in beide Richtungen abstrahlen, wie in Abstrahlrichtung 20 dargestellt. Der vertikale Versatz der strahlungsemittierenden, organischen Bauelemente 10 zueinander wird über Planarisierungsschichten, beispielsweise Gießharz ausgeglichen, so dass die Oberflächenanmutung planar ist.

Auch mit dieser Anordnung wird das Verhältnis von leuchtender Fläche zur Gesamtfläche verbessert, entsprechend der in Figur 4A beschriebenen Beispiele.

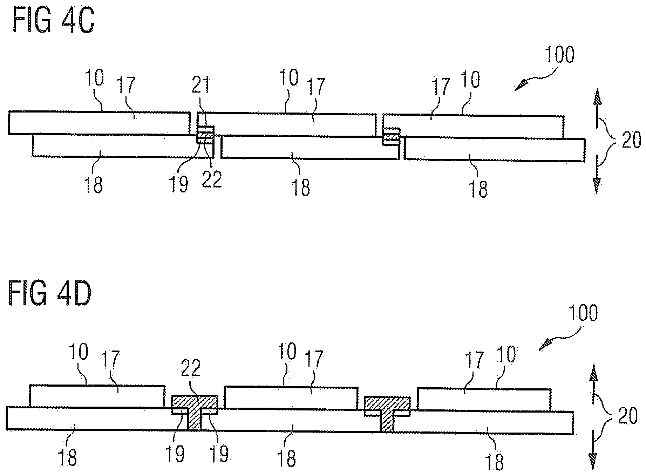

Figur 4C zeigt ein weiteres Beispiel einer strahlungsemittierenden Vorrichtung 100, das nicht zur Erfindung gehört, mit überlappenden Kontaktbereichen. Dargestellt sind drei strahlungsemittierende, organische Bauelemente 10, mit jeweils einer Verkapselung 17 und jeweils einem Substrat 18. Bei jedem strahlungsemittierenden, organischen Bauelement 10 ist dabei die Verkapselung 17 gegenüber dem Substrat 18 derart verschoben, dass auf der linken Seite jeweils ein Verkapselungskontaktbereich 21 und auf der rechten Seite jeweils ein Substratkontaktbereich 19 gebildet wird. Die elektrische Verbindung zwischen den einzelnen strahlungsemittierenden, organischen Bauelementen 10 wird dabei über eine leitende Verbindung 22 hergestellt. Mit der gezeigten strahlungsemittierenden Vorrichtung 100 kann Licht entsprechend der dargestellten Abstrahlrichtung 20 nach oben und nach unten abgestrahlt werden.

Mit der Überlappung der Kontaktbereiche der strahlungsemittierenden, organischen Bauelemente 10 wird das Verhältnis von leuchtender Fläche zur Gesamtfläche verbessert. Es können dabei Faktoren wie in den unter Figur 4A beschriebenen Beispielen erreicht werden.

Figur 4D zeigt ein weiteres Beispiel einer strahlungsemittierenden Vorrichtung 100, das nicht zur Erfindung gehört. Dargestellt sind drei strahlungsemittierende, organische Bauelemente 10, die jeweils ein Substrat 18 und jeweils eine Verkapselung 17 aufweisen. Die strahlungsemittierenden, organischen Bauelemente 10 bilden dabei jeweils auf ihrer rechten und ihrer linken Seite jeweils einen Substratkontaktbereich 19 aus. Die strahlungsemittierenden, organischen Bauelemente 10 sind dabei benachbart zueinander angeordnet, so dass Seitenfläche neben Seitenfläche entsprechend einer Stoßkontaktierung zum Liegen kommt. Die elektrische Kontaktierung der jeweiligen Substratkontaktbereiche 19 benachbarter strahlungsemittierender, organischer Bauelemente 10 wird dabei über eine leitende Verbindung 22 realisiert. Die leitende Verbindung 22 kann dabei beispielsweise eine Leitpaste oder einen so genannten Anisotropic Conductive Film umfassen. Über diese leitende Kontaktierung 22 werden die strahlungsemittierenden, organischen Bauelemente 10 auch mechanisch miteinander verbunden, beispielsweise verklebt. Dargestellt ist auch die Abstrahlrichtung 20, die in diesem Fall nach oben und nach unten weist.

## Patentansprüche

1. Strahlungsemittierende Vorrichtung (100) aufweisend ein erstes und mindestens ein zweites strahlungsemittierendes, organisches Bauelement (10) mit
- jeweils einem Substrat (18) mit einer ersten Hauptfläche, auf die eine erste Elektrode aufgebracht ist,
- jeweils einer auf der ersten Elektrode angeordneten organischen Schichtenfolge, wobei die organische Schichtenfolge mindestens eine organische Schicht aufweist, die geeignet ist, Strahlung zu erzeugen,
- jeweils einer auf der organischen Schichtenfolge angeordneten zweiten Elektrode und
- jeweils einer auf dem Substrat (18) über der organischen Schichtenfolge und der zweiten Elektrode angeordneten Verkapselung (17),
wobei das erste strahlungsemittierende, organische Bauelement (10) mit dem mindestens zweiten strahlungsemittierenden, organischen Bauelement (10) elektrisch und mechanisch verbunden ist,
**dadurch gekennzeichnet, dass**
die Verbindung zwischen dem ersten und dem mindestens zweiten strahlungsemittierenden, organischen Bauelement (10) als flexible Kontaktbrücke ausgebildet ist, wobei die flexible Kontaktbrücke flexibler als das Substrat (18) des ersten und des mindestens zweiten strahlungsemittierenden, organischen Bauelements (10) ausgeführt ist und die flexible Kontaktbrücke als klemmbarer, metallisch verbrückter Doppelpin ausgeführt ist.

2. Strahlungsemittierende Vorrichtung (100) nach Anspruch 1,
aufweisend eine verformbare Ummantelung (9), die das erste und das damit verbundene mindestens zweite strahlungsemittierende, organische Bauelement (10) umschließt,
wobei die verformbare Ummantelung (9) einen für die von den strahlungsemittierenden, organischen Bauelementen (10) emittierte Strahlung transparenten Kunststoff umfasst.

3. Strahlungsemittierende Vorrichtung (100) nach einem der vorherigen Ansprüche, mit einem tragenden Rahmen (15), in dem das erste und das mindestens zweite strahlungsemittierende, organische Bauelement (10) angeordnet und mechanisch miteinander verbunden sind,
wobei die strahlungsemittierenden, organischen Bauelemente (10) über den tragenden Rahmen (15) elektrisch miteinander verbunden sind.

4. Strahlungsemittierende Vorrichtung (100) nach Anspruch 3,
wobei der tragende Rahmen (15) als flexibles Trägergitter mit quer zueinander verlaufenden Stegstrukturen ausgeführt ist, wobei das Material des flexiblen Trägergitters flexibler als die jeweiligen Substrate (18) der strahlungsemittierenden, organischen Bauelemente (10) ausgeführt ist, und wobei die strahlungsemittierenden, organischen Bauelemente (10) in den Zwischenräumen des flexiblen Trägergitters angeordnet sind.

5. Strahlungsemittierende Vorrichtung (100) nach Anspruch 4,
umfassend eine Vielzahl von strahlungsemittierenden, organischen Bauelementen (10), wobei die strahlungsemittierenden, organischen Bauelemente (10) so in dem tragenden Rahmen (15) angeordnet sind, dass jeweils ein strahlungsemittierendes, organisches Bauelement (10) in ein mit Gelenken ausgestattetes Rahmenteilstück (24) eingebettet ist, wobei die Rahmenteilstücke (24) über die Gelenke derart verbunden und gegeneinander verklappbar sind, dass der tragende Rahmen (15) ein Ziehharmonikagerüst bildet, wobei im gefalteten Zustand ein strahlungsemittierendes, organisches Bauelement (10) auf seinem benachbarten strahlungsemittierenden, organischen Bauelement (10) zum Liegen kommt und im auseinander gezogenen Zustand die strahlungsemittierenden, organischen Bauelemente (10) eine ebene Fläche bilden,
wobei der elektrische Kontakt zwischen den einzelnen strahlungsemittierenden, organischen Bauelementen (10) über elektrisch leitende Bereiche (16) des tragenden Rahmens (15) erfolgt.

6. Strahlungsemittierende Vorrichtung (100) nach Anspruch 4,
wobei der tragende Rahmen (15) als Textilstoff ausgeführt ist, in den die strahlungsemittierenden, organischen Bauelemente (10) eingelagert sind.

7. Selbsttragendes, strahlungsemittierendes Baumaterial, aufweisend mindestens eine strahlungsemittierende Vorrichtung (100) nach einem der Ansprüche 1 bis 4,
wobei das selbsttragende, strahlungsemittierende Baumaterial als begehbare Beleuchtung einsetzbar ist.

8. Beleuchtungseinrichtung (100), aufweisend eine Vielzahl von strahlungsemittierenden, organischen Bauelementen (10), einem tragenden Rahmen (15) und einem flexiblen Deckel,
wobei die strahlungsemittierenden, organischen Bauelemente (10) jeweils ein Substrat (18) mit einer ersten Hauptfläche aufweisen, auf die eine erste Elektrode, darauf eine organische Schichtenfolge mit mindestens einer organischen Schicht, die geeignet ist, Strahlung zu erzeugen, und darauf einer zweiten Elektrode aufgebracht sind, und auf dem Substrat (18) über der organischen Schichtenfolge und der zweiten Elektrode eine Verkapselung (17) angeordnet ist,
**dadurch gekennzeichnet, dass**
der tragende Rahmen (15) als flexibles Trägergitter mit quer zueinander verlaufenden Stegstrukturen ausgeführt ist,
das Material des flexiblen Trägergitters flexibler als die jeweiligen Substrate (18) der strahlungsemittierenden, organischen Bauelemente (10) ausgeführt ist,
die strahlungsemittierenden, organischen Bauelemente (10) in den Zwischenräumen des flexiblen Trägergitters angeordnet sind,
die strahlungsemittierenden, organischen Bauelemente (10) matrixartig in dem flexiblen Trägergitter angeordnet und mechanisch miteinander verbunden sind und über das flexible Trägergitter parallel, seriell oder in einer Kombination aus parallel und seriell elektrisch miteinander verbunden sind,
auf dem flexiblen Trägergitter und der Vielzahl von strahlungsemittierenden, organischen Bauelementen (10) der flexible Deckel befestigt ist und
das Material des flexiblen Deckels eine gleichgroße Flexibilität wie das Material des flexiblen Trägergitters aufweist.

## Claims

1. Radiation-emitting device (100) having a first and at least a second radiation-emitting organic component (10) comprising
- in each case a substrate (18) having a first main area, to which a first electrode is applied,
- in each case an organic layer sequence arranged on the first electrode, wherein the organic layer sequence has at least one organic layer suitable for generating radiation,
- in each case a second electrode arranged on the organic layer sequence, and
- in each case an encapsulation (17) arranged on the substrate (18) above the organic layer sequence and the second electrode,
wherein the first radiation-emitting organic component (10) is electrically and mechanically connected to the at least second radiation-emitting organic component (10), **characterized in that** the connection between the first and the at least second radiation-emitting organic component (10) is formed as a flexible contact bridge, wherein the flexible contact bridge is embodied such that it is more flexible than the substrate (18) of the first and of the at least second radiation-emitting organic component (10) and the flexible contact bridge is embodied as a clampable, metallically bridged double pin.

2. Radiation-emitting device (100) according to Claim 1, having a deformable sheathing (9) enclosing the first and the at least second radiation-emitting organic component (10) connected thereto wherein the deformable sheathing (9) comprises a plastic that is transparent to the radiation emitted by the radiation-emitting organic components (10).

3. Radiation-emitting device (100) according to any of the preceding claims, comprising a carrying frame (15), in which the first and the at least second radiation-emitting organic component (10) are arranged and mechanically connected to one another
wherein the radiation-emitting organic components (10) are electrically connected to one another via the carrying frame (15).

4. Radiation-emitting device (100) according to Claim 3,
wherein the carrying frame (15) is embodied as a flexible carrier grid with web structures running transversely with respect to one another, wherein the material of the flexible carrier grid is embodied such that it is more flexible than the respective substrates (18) of the radiation-emitting organic components (10), and wherein the radiation-emitting organic components (10) are arranged in the interspaces of the flexible carrier grid.

5. Radiation-emitting device (100) according to Claim 4, comprising a multiplicity of radiation-emitting organic components (10), wherein the radiation-emitting organic components (10) are arranged in the carrying frame (15) in such a way that a respective radiation-emitting organic component (10) is embedded into a frame segment (24) equipped with articulated joints, wherein the frame segments (24) are connected via the articulated joints and can be folded relative to one another in such a way that the carrying frame (15) forms an accordion framework, wherein, in the folded state, a radiation-emitting organic component (10) is situated on its adjacent radiation-emitting organic component (10) and, in the spread-out state, the radiation-emitting organic components (10) form a plane area wherein the electrical contact between the individual radiation-emitting organic components (10) is effected via electrically conductive regions (16) of the carrying frame (15).

6. Radiation-emitting device (100) according to Claim 4,
wherein the carrying frame (15) is embodied as textile material into which the radiation-emitting organic components (10) are incorporated.

7. Self-supporting, radiation-emitting structural material, having at least one radiation-emitting device (100) according to any of Claims 1 to 4,
wherein the self-supporting, radiation-emitting structural material can be used as floor lighting.

8. Illumination device (100), having a multiplicity of radiation-emitting organic components (10),
a carrying frame (15) and a flexible cover,
wherein the radiation-emitting organic components (10) have in each case a substrate (18) having a first main area, to which a first electrode, thereon an organic layer sequence having at least one organic layer suitable for generating radiation, and thereon a second electrode are applied, and an encapsulation (17) is arranged on the substrate (18) above the organic layer sequence and the second electrode,
**characterized in that**
the carrying frame (15) is embodied as a flexible carrier grid with web structures running transversely with respect to one another,
the material of the flexible carrier grid is embodied such that it is more flexible than the respective substrates (18) of the radiation-emitting organic components (10),
the radiation-emitting organic components (10) are arranged in the interspaces of the flexible carrier grid,
the radiation-emitting organic components (10) are arranged in matrixlike fashion in the flexible carrier grid and are mechanically connected to one another and are electrically connected to one another in parallel, in series or in a combination of in parallel and in series via the flexible carrier grid, the flexible cover is fixed on the flexible carrier grid and the multiplicity of radiation-emitting organic components (10) and
the material of the flexible cover has a flexibility equal in magnitude to that of the material of the flexible carrier grid.

## Revendications

1. Dispositif émetteur de rayonnement (100) possédant un premier et au moins un deuxième composant organique (10) émetteur de rayonnement, comprenant
- respectivement un substrat (18) ayant une première surface principale sur laquelle est disposée une première électrode,
- respectivement une séquence de couches organiques disposées sur la première électrode, la séquence de couches organiques possédant au moins une couche organique qui est conçue pour générer un rayonnement,
- respectivement une deuxième électrode disposée sur séquence de couches organiques et
- respectivement un encapsulage (17) disposé sur le substrat (18) au-dessus de la séquence de couches organiques et de la deuxième électrode,
le premier composant organique (10) émetteur de rayonnement étant relié électriquement et mécaniquement avec l'au moins un deuxième composant organique (10) émetteur de rayonnement,
**caractérisé en ce que**
la liaison entre le premier et l'au moins un deuxième composant organique (10) émetteur de rayonnement est réalisée sous la forme d'un cavalier de contact flexible, le cavalier de contact flexible étant réalisé plus flexible que le substrat (18) du premier et de l'au moins un deuxième composant organique (10) émetteur de rayonnement et le cavalier de contact flexible étant réalisé sous la forme d'une double broche métallique pontée par métallisation et pouvant être serrée.

2. Dispositif émetteur de rayonnement (100) selon la revendication 1, possédant un enrobage (9) déformable qui entoure le premier composant organique (10) émetteur de rayonnement et l'au moins un deuxième relié à celui-ci, l'enrobage (9) déformable comprenant une matière plastique transparente pour le rayonnement émis par les composants organiques (10) émetteurs de rayonnement.

3. Dispositif émetteur de rayonnement (100) selon l'une des revendications précédentes, comprenant un cadre porteur (15) dans lequel le premier et l'au moins un deuxième composant organique (10) émetteur de rayonnement sont disposés et reliés mécaniquement entre eux, les composants organiques (10) émetteurs de rayonnement étant reliés électriquement entre eux par le biais du cadre porteur (15).

4. Dispositif émetteur de rayonnement (100) selon la revendication 3, le cadre porteur (15) étant réalisé sous la forme d'une grille porteuse pourvue de structures à éléments jointifs s'étendant transversalement les unes par rapport aux autres, le matériau de la grille porteuse flexible étant réalisé plus flexible que les substrats (18) respectifs des composants organiques (10) émetteurs de rayonnement et les composants organiques (10) émetteurs de rayonnement étant disposés dans les espaces intermédiaires de la grille porteuse flexible.

5. Dispositif émetteur de rayonnement (100) selon la revendication 4,
comprenant une pluralité de composants organiques (10) émetteurs de rayonnement, les composants organiques (10) émetteurs de rayonnement étant disposés dans le cadre porteur (15) de telle sorte qu'un composant organique (10) émetteur de rayonnement est à chaque fois enrobé dans un tronçon de cadre (24) équipé d'articulation, les tronçons de cadre (24) étant reliés par le biais des articulations et pouvant être rabattus les uns contre les autres de telle sorte que le cadre porteur (15) forme une ossature en accordéon, avec laquelle, dans l'état plié, un composant organique (10) émetteur de rayonnement vient reposer sur le composant organique (10) émetteur de rayonnement qui lui est voisin et, dans l'état déployé, les composants organiques (10) émetteurs de rayonnement forment une surface plane,
le contact électrique entre les composants organiques (10) émetteurs de rayonnement individuels s'effectuant par le biais de zones électriquement conductrice (16) du cadre porteur (15).

6. Dispositif émetteur de rayonnement (100) selon la revendication 4, le cadre porteur (15) étant réalisé sous la forme d'une matière textile dans laquelle sont incorporés les composants organiques (10) émetteurs de rayonnement.

7. Matériau de construction autoportant émetteur de rayonnement, possédant un dispositif émetteur de rayonnement (100) selon l'une des revendications 1 à 4, le matériau de construction autoportant émetteur de rayonnement pouvant être utilisé comme éclairage accessible aux piétons.

8. Appareil d'éclairage (100) possédant une pluralité de composants organiques (10) émetteurs de rayonnement, un cadre porteur (15) et un couvercle flexible,
les composants organiques (10) émetteurs de rayonnement possédant respectivement un substrat (18) ayant une première surface principale sur laquelle est disposée une première électrode, sur laquelle est disposée une séquence de couches organiques ayant au moins une couche organique qui est conçue pour générer un rayonnement, et là-dessus une deuxième électrode, et un encapsulage (17) est disposé sur le substrat (18) au-dessus de la séquence de couches organiques et de la deuxième électrode,
**caractérisé en ce que**
le cadre porteur (15) est réalisé sous la forme d'une grille porteuse pourvue de structures à éléments jointifs s'étendant transversalement les unes par rapport aux autres,
le matériau de la grille porteuse flexible est réalisé plus flexible que les substrats (18) respectifs des composants organiques (10) émetteurs de rayonnement,
les composants organiques (10) émetteurs de rayonnement sont disposés dans les espaces intermédiaires de la grille porteuse flexible,
les composants organiques (10) émetteurs de rayonnement sont disposés à la manière d'une matrice dans la grille porteuse flexible et sont reliés mécaniquement entre eux, et sont reliés mécaniquement entre eux et sont reliés électriquement entre eux en parallèle, en série ou en une combinaison parallèle et série par le biais de la grille porteuse flexible,
le couvercle flexible est fixé sur la grille porteuse flexible et la pluralité de composants organiques (10) émetteurs de rayonnement et
le matériau du couvercle flexible présente une flexibilité identique à celle du matériau de la grille porteuse flexible.
